# EUROPEAN PATENT SPECIFICATION

(11) **EP 0 543 506 B1**
(45) Date of publication and mention of the grant of the patent: **05.03.1997**
(21) Application number: 92309674.7
(22) Date of filing: 22.10.1992
(51) Int. Cl.: G06F 11/26

(54) **Enhanced boundary-scan interconnect test diagnosis through utilization of board topology data**
Verbesserte Diagnose der Verbindungsprüfung mittels "boundary-scan"-Technik durch Ausnutzung von Leiterplatten-Datentopologie
Diagnostic de test d'interconnexion à "boundary scan" amélioré par l'utilisation de données de topologie de circuit imprimé

(30) Priority: 19.11.1991 US 794767
(43) Date of publication of application: 26.05.1993
(73) Proprietor: Hewlett-Packard Company, Palo Alto, California 94304 (US)
(72) Inventor: Parker, Kenneth P., Ft. Collins CO 80525 (US); Posse, Kenneth E., Fort Collins, CO 80525 (US)
(74) Representative: Colgan, Stephen James

(56) References cited:
- 1989 PROCEEDINGS INTERNATIONAL TEST CONFERENCE 29 August 1989 , WASHINGTON DC pages 63 - 70 XP000089931 JARWALA AND YAU 'A NEW FRAMEWORK FOR ANALYZING TEST GENERATION AND DIAGNOSIS ALGORITHM FOR WIRING INTERCONNECTS'
- PROCEEDINGS 1988 INTERNATIONAL TEST CONFERENCE 12 September 1988 , WASHINGTON DC US pages 126 - 137 XP000013045 HASSAN ET AL 'TESTING AND DIAGNOSIS OF INTERCONNECTS USING BOUNDARY SCAN ARCHITECTURE'

## Description

### Background of the Invention

### 1. Field of the Invention

The present invention relates to the field of boundary-scan interconnect testing of circuit boards. More specifically, the invention relates to a method for enhancing the diagnostic resolution of a boundary-scan interconnect test after it has been executed.

### 2. Background Art

Testing complex digital circuitry at the circuit board level is frequently performed on an ATE (Automated Test Equipment) system. The HP3070 tester is an example of an ATE system. The HP3070 is available from Hewlett-Packard Company, Palo Alto, California. Detailed operational information for the HP3070 is contained in "HP3070 Board Test System User's Documentation Set (1989)" available from Hewlett-Packard under HP part number 44930A.

Testing performed on an ATE system includes functional test and in-circuit test. Functional test conventionally involves providing input signals to the external inputs of a circuit board and observing output signals from the external outputs of the board. This type of testing becomes quite complex for large circuits and can provide only limited diagnostics.

Modern testing increasingly supplements this traditional functional test with in-circuit component test. In-circuit component test is a type of functional test wherein the performance of each digital integrated circuit (IC) is tested as a functional unit. That is, each component (e.g., digital IC) on the board is tested as if it were electrically isolated from the surrounding circuit. In order to perform the in-circuit component test, the tester (e.g., ATE) must apply input signals directly to the inputs of a DUT (device under test) and must access the outputs of the DUT to observe the output response.

An ATE system, such as the HP3070, uses a "bed-of-nails" (i.e., probes which directly make contact with device I/O pins from pads on the surface of the board) fixture to access the required nodes on a board. Unfortunately, the nodal access required by in-circuit test is often hampered by increasing circuit complexity (e.g., miniaturized components, multi-chip modules, ASIC's, etcetera) and increasing use of such technologies as surface mount and silicon-on-silicon.

The development of boundary-scan has facilitated in-circuit testing by improving nodal access. Boundary-scan is a standardized (e.g., IEEE Standard 1149.1 - 1990) test technique which involves devices designed with shift registers placed between each device pin and the internal logic of an IC chip. This provides a tester with access to every input and output signal on the boundary-scan chip, and allows the tester to control the I/O pins independent of the core logic and/or to control the core logic independent of the I/O pins.

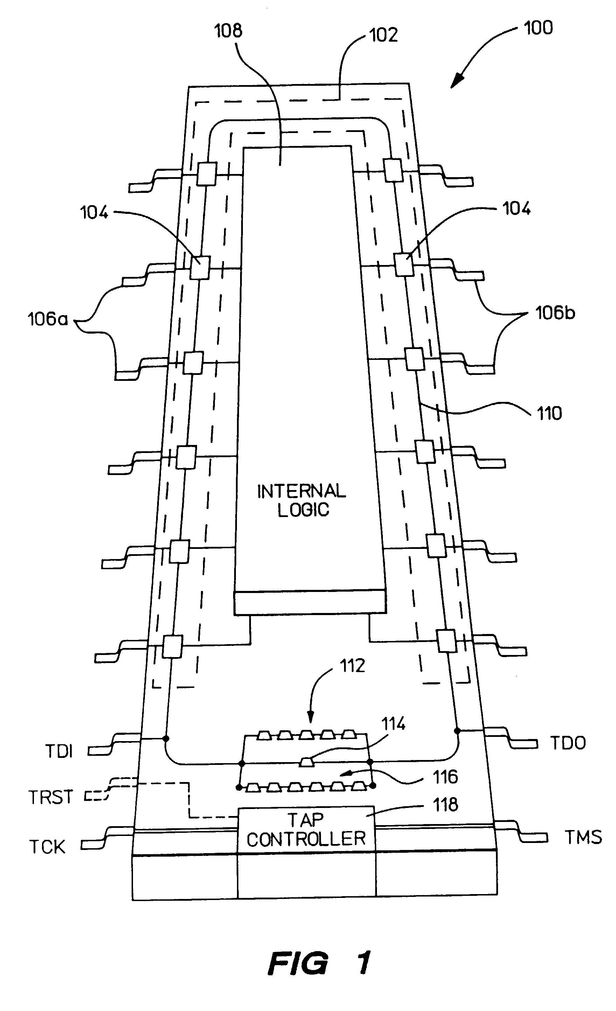

For example, a boundary-scan IC chip 100 is shown in Figure 1. A boundary register 102 is formed from a plurality of boundary register cells 104. Each cell 104 is disposed between an I/O (input/output) terminal 106(a)-(b) and the internal logic 108 of chip 100. As a matter of convention, input terminals 106(a) are shown on the left-hand side of chip 100, and output terminals 106(b) are shown on the right-hand side of chip 100. Some of the I/O terminals may be bidirectional. Bidirectional pins, however, are fixed as either an input or an output for the duration of the test. Thus, bidirectional pins are shown as either an input or an output.

A scanpath or scanchain 110 is formed through boundary register 102. An IDCODE (i.e., identification) register 112, a bypass register 114, and an instruction register 116 are also included in chip 100. IDCODE register 112 provides identification data for chip 100. Bypass register 114 is a one-bit register which allows boundary register 102 to be bypassed. Instruction register 116 decodes instruction bits which are used to select test mode and also to control the operational mode of the chip during test.

A test access port (TAP) controller 118 is a state machine which controls boundary register 102. Five I/O terminals have been added to chip 100 to accommodate boundary-scan. These five terminals constitute the test access port (TAP). A TDI (test data in) terminal provides serial test data and instruction bits to scanpath 110. A TDO (test data out) terminal provides serial output for scanpath 110. A TCK (test clock) terminal provides an independent test clock to chip 100. A TMS (test mode select) terminal provides the logic levels needed to change the state of TAP controller 118. A TRST (test rest) terminal is used to reset chip 100. The TRST terminal, shown in phantom, is optional.

A more detailed discussion on boundary-scan is provided in IEEE Std 1149.1 - 1990, "IEEE Standard Test Access Port and Boundary-Scan Architecture," IEEE Standards Board and "HP Boundary-Scan Tutorial and BSDL Reference Guide," Hewlett-Packard Company, HP part number E1017-90001.

Most relevant to the present invention is the use of boundary-scan for interconnect testing. In production testing of boards, device interconnects (e.g., printed circuit traces) are tested prior to mounting components thereon. Likewise, the components are tested prior to mounting on the board. Once the components are mounted on the board, it is desirable to re-test the interconnects. This test is called a boundary-scan interconnect test.

The boundary-scan interconnect test seeks to locate problems which are introduced during installation of the integrated circuit chips (IC's) on the circuit board. The primary faults include opens, shorts, missing or wrong components, and mis-oriented (e.g., rotated 180°) components. Opens frequently result from broken pins or "cold" solder joints. Shorts may be caused by excess solder bridging the gap from one IC pin connection to the next.

An interconnect test involves testing each conductive "net" or "node" on the board to ensure that it connects the proper devices (e.g., input and/or output buffers of one or more IC chips). A "net" or "node" is defined as an equipotential surface formed by a physical conductor.

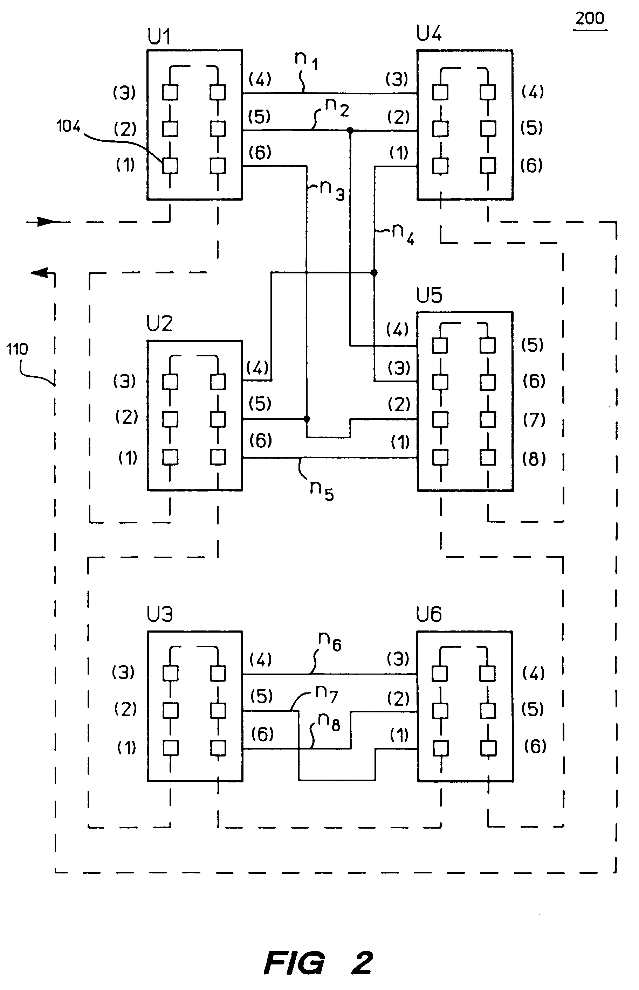

A sample circuit 200 to be tested is shown in Figure 2. Circuit 200 includes six interconnected IC's U1-U6. Boundary register cells 104 are shown in each IC. Following convention, input cells are shown on the left-hand side of each IC, and output cells are shown on the right-hand side of each IC. Each pin of each IC is numbered consecutively from the lower left-hand corner and is referenced by that number along with the IC reference number. For example, U1-3 refers to pin 3 of U1.

A scanpath 110 is shown connecting register cells 104 of IC's U1-U6. Cells 104 in scanpath 110 form the boundary register (102 in Figure 1). A net n₁ connects U1-4 to U4-3. A net n₂ connects U1-5 to U4-2 and U5-4. A net n₃ connects U1-6 and U2-5 to U5-2. A net n₄ connects U2-4 to U4-1 and U5-3. A net n₅ connects U2-6 to U5-1. A net n₆ connects U3-4 to U6-3. A net n₇ connects U3-5 to U6-1. A net n₈ connects U3-6 to U6-2.

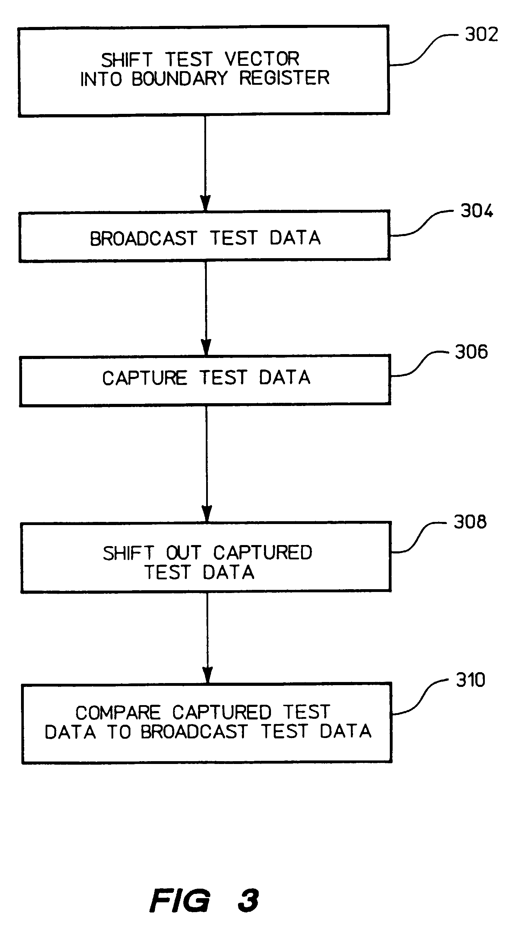

The method of boundary-scan interconnect testing circuit 200 is shown in Figure 3. At step 302, a test vector (i.e., test data) is serially shifted into boundary register 102. At step 304, the test vector is broadcast from appropriate output buffers (drivers) over the corresponding nets to receiving input buffers. The broadcast data is then captured into the receiving register cells at step 306. The captured test data is shifted out of boundary register 102 at step 308. Finally, the captured test data is compared to the broadcast test data at step 310. Differences in the captured and broadcast data indicate a fault. Because the captured test data contains information on the condition of the net over which it was broadcast, it is also called a "net signature" herein.

A single test vector can detect a fault; however, it provides very little diagnostic information. Therefore, in order to diagnose a fault condition, a plurality of test vectors are required. After the plurality of test vectors have been broadcast and captured, the captured data is analyzed for fault diagnosis.

Note that net n₃ is driven by two drivers (U1-6 and U2-5). An optimal test method will not test both of these drivers during boundary-scan test because it is inefficient and unnecessarily complicates the boundary-scan test. Instead, one driver is selected and designated for use in the interconnect test. The other driver will be added to a list of non-designated drivers. At completion of the interconnect test, the non-designated drivers will be tested during a bus test (i.e., a test to verify connection only since testing for short circuits has already been performed by the boundary-scan interconnect test). The bus test can be performed very quickly by testing all non-designated drivers in parallel.

Interconnect faults include single-net faults and multi-net faults. Single-net faults involve only one net and include stuck HIGH, stuck LOW and open faults. Multi-net faults are caused by shorts which connect two or more nets. Single-net faults are simple to detect and locate. Multi-net faults, however, can be difficult to diagnose. For example, two short-circuited nodes can "alias" (i.e., behave) identically to a third good node such that it is not possible to determine whether the third good node is also involved in the short-circuit. Similarly, it is possible for two short-circuits, each involving two or more nodes, to have the identical behavior such that it is not clear whether there is one large short-circuit or two independent short-circuits. This phenomenon is known as "confounding".

The actual outcome of a multi-net fault will depend on the type of nets involved. The three types of nets include: simple nets, wire nets, and three-state nets. A simple net is driven by a single buffer/driver. A wire net is a net which is driven by more than one buffer/driver. A wire net may be either a wire-AND or a wire-OR net. A wire-AND net is a net having drivers which have a dominant LOW state. That is, if two drivers are shorted together, a LOW signal will dominate such that a logical AND of the signals results. A wire-OR net is a net having drivers which have a dominant HIGH state. That is, if two drivers are shorted together, a HIGH signal will dominate such that a logical OR of the signals results. A three-state net is a net which is driven by more than one three-state buffer/driver.

The result of multi-net faults may be deterministic (predictable) or non-deterministic (non-predictable). Deterministic faults include OR-type shorts (i.e., shorts between wire-OR nets), AND-type shorts (i.e., shorts between wire-AND nets), and strong-driver shorts (i.e., a short between nets wherein a dominant driver controls the state of the nets regardless of other drivers). For a more detailed analysis of fault diagnosis, see N. Jarwala and C. W. Yau, "A New Framework for Analyzing Test Generation and Diagnosis Algorithms for Wiring Interconnects," Proceedings of International Test Conference 1989, pp. 63-70 (IEEE Order No. CH2742-5/0000/0063).

In performing the interconnect boundary-scan test, it is sought to use a test pattern which will detect a fault (i.e., an interconnect problem) and which will provide diagnostic information useful for locating the fault. In addition, it is desirable to keep the test pattern as short as possible because each test vector must be serially shifted into (and out of) the boundary register one bit each test cycle.

Unfortunately, these goals are in conflict such that brevity is often sacrificed for diagnostic capability and visa versa. A test pattern which has brevity as its primary concern is called a brief test pattern. Brief test patterns tend to provide limited diagnostics. A test pattern which is primarily concerned with diagnostic capabilities is called a high diagnostic test pattern. High diagnostic test patterns tend to be lengthy.

### Walking Bit Test Pattern

For example, the "walking bit" is a conventional test pattern which provides optimal diagnostic resolution. The walking bit pattern assigns a unique ID (identification) number to each net. Each ID number contains a single complementary bit (e.g., a logical HIGH or logical LOW) in a field of otherwise identical bits. The single complementary bit is in a different, unique bit position or column for each ID number. For example, a walking ones pattern has a single logical HIGH or "1" bit.

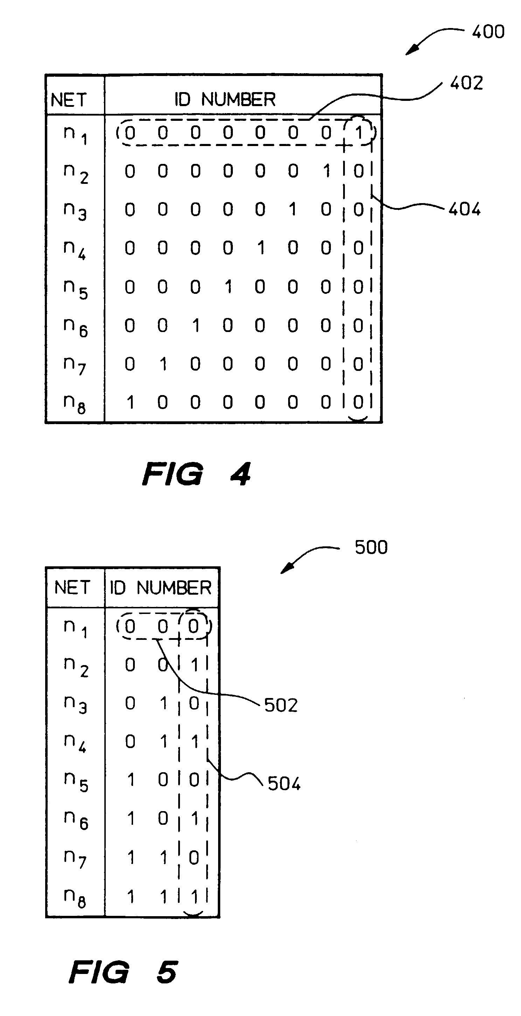

Figure 4 shows a walking ones test pattern which could be used to test circuit 200. After a unique walking ones net ID number has been assigned to each net, a matrix 400 of test data results. The horizontal rows of the matrix contain the net ID numbers, while the vertical columns contain the test frames or test vectors to be broadcast. A sample net ID number 402 which has been assigned to net n₁ and a test vector 404 are indicated.

Note that each test vector contains a single "1" according to the walking ones test pattern. Thus, only a single "1" will be broadcast in each test vector and on each net during the test. Since only a single "1" is used in each test vector, it is straightforward to identify which nets are shorted together and which nets are open. Thus, very good diagnostic resolution is available.

A principal failing of the walking bit test is that it is large (i.e., requires a large amount of tester memory), lengthy, and can become unmanageable for large circuits. The number of test cycles required for the walking bit pattern is a function of (e.g., proportional to) the number of test vectors times the number of test signals (bits) per vector, or simply the number of nets squared (N²). For the eight net example given in Figure 4, a complete test requires eight test vectors, each test vector being eight bits long. This equates to 8² or 64 test cycles. For a circuit having 5000 nets, the test length would be proportional to 5000² or 25 million test cycles.

### Counting Test Pattern

An example of a brief test pattern is the counting test pattern. The counting test is an alternative to the walking bit pattern. The counting pattern assigns a unique ID number to each net. The net ID numbers are increased in binary counting fashion such that a logarithmic compression in the number of test vectors results.

A sample counting pattern for circuit 200 is shown in Figure 5. A matrix 500 of test vectors is formed from the ID numbers. The horizontal rows of the matrix contain the net ID numbers, while the vertical columns contain the test frames or test vectors to be broadcast. A sample net ID number 502 assigned to net n₁ and a sample test vector 504 are indicated.

Note that matrix 500 contains only four test vectors rather than eight as the walking bit pattern requires. In general, the walking bit pattern requires N test vectors, where N is equal to the number of nets in the circuit. Contrast the counting pattern which requires only log₂(N) (rounded to the next highest integer) test vectors. For the eight net example given in Figure 5, a complete counting pattern test requires three test vectors, each test vector being eight bits long. Thus, the test length is proportional to 24 test cycles. Similarly, a 5000 net circuit would require 13 test vectors and have a test length proportional to 65,000 test cycles. This is a substantial savings in test resources over the walking bit test.

A disadvantage of the reduced number of test vectors is a corresponding decrease in the diagnostic resolution of the test. For example, net N₁ might be open-circuited and still produce the "000" ID number. Similarly, a short-circuit between nets n₂ and n₃ with wire-OR nets will produce (i.e., alias) the ID number for n₄ such that it may not be possible to determine if n₄ is also short-circuited.

### Enhanced Test Pattern

EP-A-0 671 689 (published on 13.09.95) discloses a test which provides the detailed diagnostics of a walking bit test pattern with the speed and brevity of a counting test pattern. Unlike the conventional test methods which construct a test pattern entirely in the logical domain, this method takes into account the physical description of the circuit under test. This allows a custom test pattern to be generated for each circuit to be tested. The test method keys on the fact that shorts are most likely to result from solder bridges between closely adjacent pins.

Nets which have radially adjacent pins are grouped together. Each net in a group is then assigned a unique net ID number according to a high diagnostic test pattern. Nets which are common to more than one group receive only a single unique net ID number. Each group is assigned a unique group ID number according to a brief test pattern.

The group ID number is appended to each net ID number to form a unique net identifier for each net. The unique net identifiers are combined to form a matrix. Each row of the matrix is one of the unique net identifiers. Each column of the matrix is a unique test vector available for boundary scan testing.

By using physical data describing the circuit board under test to reduce the possible combinations which can result from short-circuits, this method provides a relatively short test with high diagnostic capabilities. Because this solution is a single dimensional solution to a multi-dimensional problem and because several imperfect assumptions are made, however, the possibility of aliasing is still present.

### Adaptive Test Pattern

The prior attempts discussed above have tried to eliminate aliasing and confounding solely during the test generation stage. Adaptive algorithm methods, on the other hand, attempt to remedy these problems during execution of the test. These methods typically use a brief test method (e.g., a counting sequence) to identify a small subset of bad nets. A high-diagnostic test method (e.g., a walking ones sequence) is then dynamically derived and executed on this subset of bad nets to provide detailed diagnostics. This adaptive approach, however, is time consuming and resource expensive.

What is needed is a time and resource efficient method for eliminating aliasing and confounding problems from a boundary-scan interconnect test.

### Summary of the Invention

The invention is a method for improving the diagnostic resolution of a boundary-scan interconnect test after the test has been executed. The invention keys on the fact that shorts are most likely to result from solder bridges between closely adjacent pins. After a test has been executed, the captured test vectors are analyzed to determine which nets have produced (i.e., captured) identical net signatures. Since each net was originally assigned a unique net ID number, a duplicated number indicates a fault.

Nets with common signatures are grouped together. Each group of nets is analyzed to determine whether a short-circuit is likely to have occurred between any of the nets within the group. This is done based on proximity (radial adjacency). It is assumed that nets which do not have proximal I/O pins are not susceptible to short-circuiting. Conversely, nets in the same group which also have radially proximal I/O pins are likely to be shorted together at the radially adjacent pins.

Thus, all nets within a group which have radially adjacent I/O pins are marked as likely short-circuited nets. Nets within a group which do not have radially adjacent I/O pins are probably not short-circuited together. The invention may be used to increase the diagnostic resolution of any boundary-scan interconnect test pattern.

The foregoing and other objects, features and advantages of the invention will be apparent from the following more particular description of a preferred embodiment of the invention, as illustrated in the accompanying drawings.

### Brief Description of the Drawings

FIG. 1 is a diagram illustrating the structure of a typical boundary-scan device.

FIG. 2 is a schematic diagram of a sample circuit used to illustrate boundary-scan testing.

FIG. 3 is a flow chart showing the steps involved in performing a boundary-scan test.

FIG. 4 is a matrix of test vectors formed for the sample circuit according to the walking ones test pattern.

FIG. 5 is a matrix of test vectors formed for the sample circuit according to the counting test pattern.

FIG. 6 is a flow chart providing an overview of the boundary-scan test method.

FIG. 7 is a high level flow chart providing an overview of the steps.

FIG. 8 is a partial block diagram of an IC chip illustrating the potential for short-circuits between radially adjacent pins.

FIG. 9 is a flow chart detailing the steps of the invention for improving the diagnostic resolution of a boundary-scan test.

### Description of the Preferred Embodiment

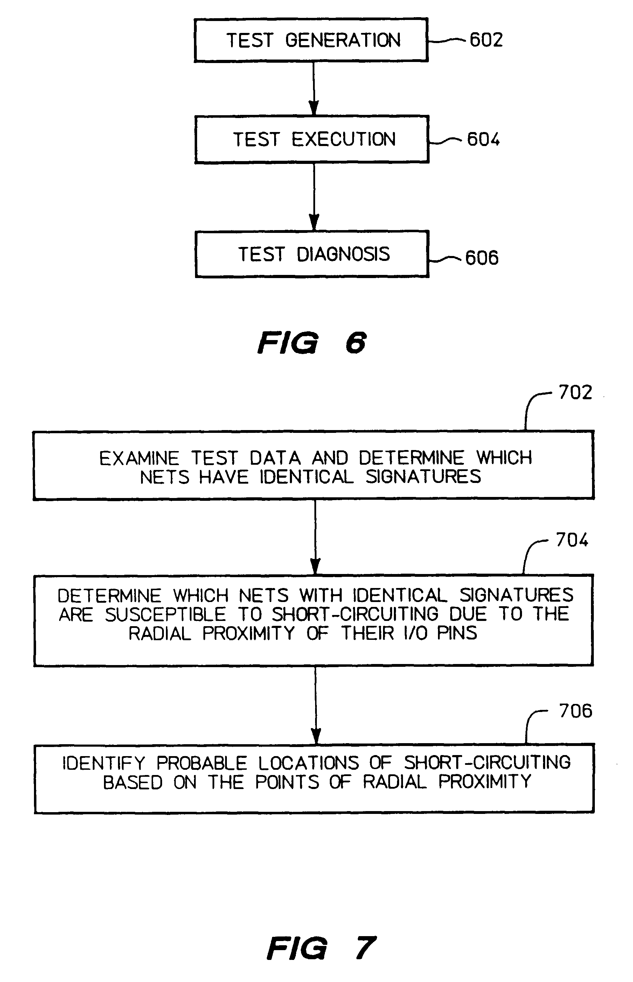

The invention is now described with reference to Figures 6-9. Figure 6 shows the three steps involved in boundary-scan interconnect testing. First, at step 602, the test patterns (i.e., test vectors) are generated. Each net is assigned a unique ID number. At step 604, the test is executed on the circuit board via an ATE system. The test results are then analyzed for test diagnosis at step 606. Test diagnosis involves analyzing the test results to locate faults.

As discussed above, conventional test methods attempt to improve test resolution (i.e., a reduction of aliasing and confounding) at the test generation phase (step 602). The inventors have discovered, however, that the test diagnosis phase (step 606) provides an excellent opportunity to increase test resolution. Further, this increase in test resolution may be used without regard to the type of test pattern generated at step 602 and executed at step 604.

In the preferred embodiment, test diagnosis (step 606) is only performed if an error occurred during test execution. During execution of the test at step 604, the captured test vectors, which are scanned out of the circuit via the scanpath, are input to an accumulator or signature generator (e.g., a parallel input polynomial signature analyzer) to produce a unique test signature. This "test signature" should not be confused with the "net signature" (introduced above), which is indicative of the condition of a single net. The test signature is produced by logically combining a series of bits in such a manner that statistically there is a very high probability that the logical combination will produce a unique test signature or end product. Since each data term input to the signature generator will affect the unique test signature, comparison with a predetermined, expected signature will indicate whether any data errors have occurred.

Figure 7 is a high-level flow chart illustrating the diagnostic method of the invention. In the preferred embodiment, this diagnostic method is performed only if a fault is indicated by the test signature as discussed above. At step 702, the test data (captured test vectors) is analyzed to determine which nets have produced (i.e., captured) identical net signatures. Each net signature is made up of the captured bits which were received at a receiving register cell of the net as a result of transmitting a unique net ID number. A successful net signature will be identical to the unique net ID number. A failure net signature will not match the transmitted net ID number.

Since each net was originally assigned a unique net ID number, a duplicated number indicates a fault. Thus, step 702 searches the captured test data to locate duplicated net signatures. At step 704, each group of nets which have a common net signature is analyzed to determine whether a short-circuit is likely to have occurred between any of the nets within a group. This is done based on proximity (as discussed below). It is assumed that only nets which have proximal I/O pins are susceptible to short-circuiting. Finally, at step 706, the probable location (or locations) of each potential short-circuit is determined based on the actual points of proximity between the nets.

In order to determine susceptibility to short-circuiting, physical layout or pin coordinate data for the circuit board under test is analyzed to determine which device I/O pins of a net are "close enough" to pins of other nets to be susceptible to shorts caused by the manufacturing/soldering process. "Close enough" is determined by comparing the radial distance between the I/O pins with a predetermined "shorting radius". The radial distance between the I/O pins is calculated from the pin coordinate data which is often in the form of x,y coordinates for each pin. This data can be obtained from CAD/CAM (Computer Aided Design / Computer Aided Manufacturing) databases for the board. The shorting radius is established by the test technician/user based on the dimensions of the circuit board and the IC pins and on the specifications from the soldering process which is used to attach the IC devices to the board.

The technician/user uses his judgment to determine the optimal shorting radius and then inputs this numerical distance into the tester. The shorting radius is then used in conjunction with the interconnect list and the physical layout data for the board to determine which nets may potentially be shorted together. Device pins which are within this predetermined radial distance shall be referred to as "radially adjacent pins" and nets having radially adjacent pins shall be called "radially adjacent nets".

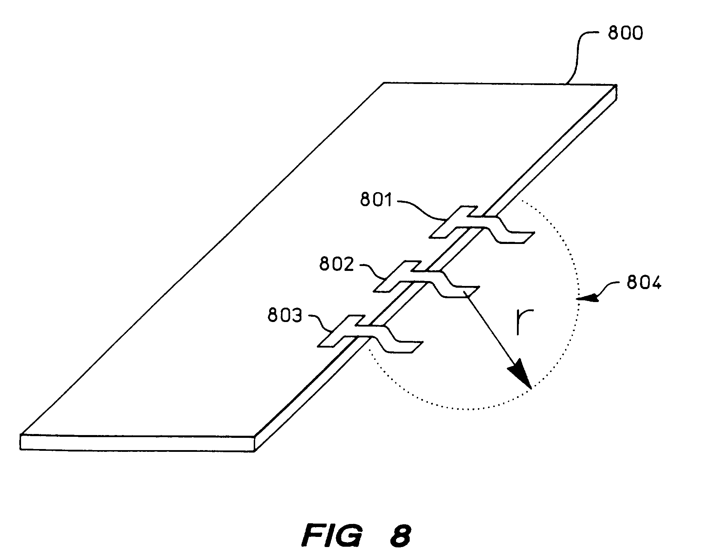

This point is illustrated with reference to Figure 8 which shows a sample integrated circuit chip (IC) 800. IC 800 includes input/output (I/O) pins 801-803. If pin 802 is selected and pins 801-803 are each connected to independent nets, then it is desirable to determine the susceptibility of pins 801 and 803 to shorting with pin 802. If it is determined that a solder bridge can potentially connect two pins at a radial distance *x* apart, then the technician/user will want to ensure that the shorting radius (*r*) is set at least as large as this distance *x*. Then, the tester must determine if pins 801 and 803 are within the radial distance *r* of pin 802. Arc 804 is shown in Figure 8 to illustrate that both pins 801 and 803 are within a radial distance *r* of pin 802. Thus, pins 801 and 803 are each radially adjacent to pin 802.

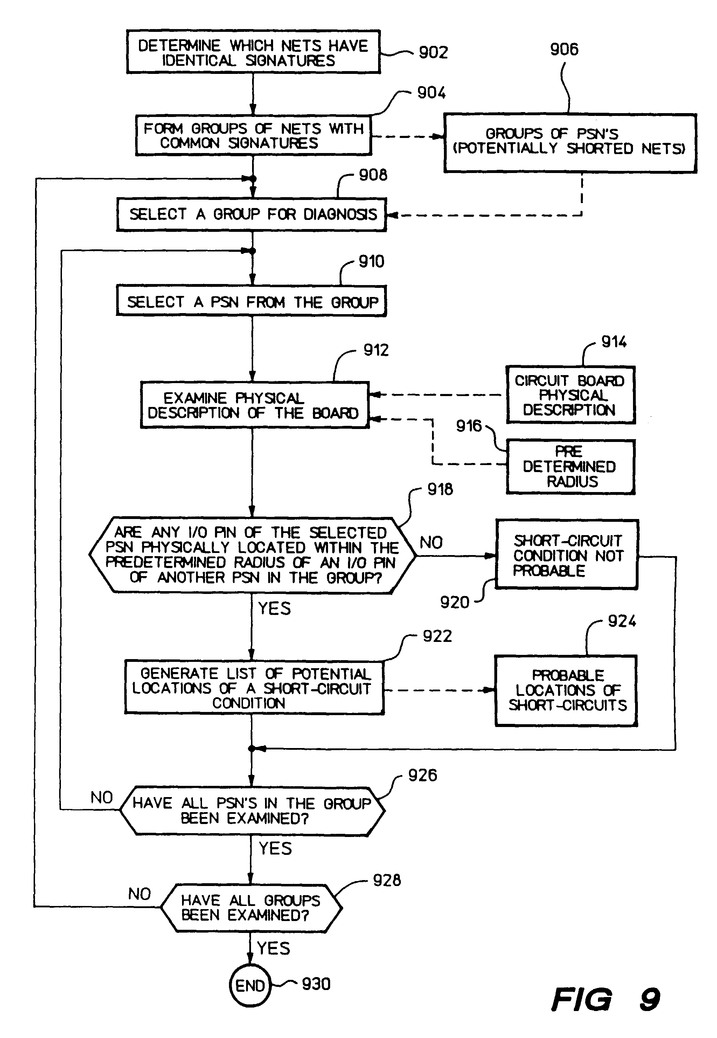

Figure 9 is a detailed flow diagram illustrating the diagnostic method of the invention. At step 902 the net signatures are analyzed to determine which nets have common net signatures. Each net having a common signature is then grouped with the nets which share the signature at step 904. Each net in a group 906 is called a PSN (potentially shorted net) since it is possible that the common signature indicates a short-circuit condition.

A group is selected for diagnosis at step 908, and a particular PSN of the selected group is then selected at step 910. At steps 912 and 918, the physical description of the board is analyzed (step 912) to determine (step 918) whether any I/O pins of the selected PSN are radially adjacent to any I/O pins of any other net in the selected group. In order to make this determination, the circuit board physical description 914 and the predetermined radius 916 are used.

Circuit board physical description 914 provides a complete topological description of the circuit board. This is an enormous amount of data which would require a large amount of test time to sift through in order to glean out the desired I/O pin interconnect and location data. Thus, in order to improve the efficiency of the method, an adjacency list is generated from physical description 914. The adjacency list includes a list of the nets on the board and, for each net, the radially adjacent nets. The adjacency list further has information on which I/O pins of the nets are radially adjacent. Thus, in the preferred embodiment, physical description 914 is an adjacency list rather than a full topological description of the circuit board.

If there are no PSN's radially adjacent to the selected PSN (step 918), then a short-circuit condition involving the selected PSN is not probable (step 920); and the method skips to step 926. If there are radially adjacent PSN's, then a list 924 of probable locations of short-circuits is generated at step 922. The list of probable short-circuit locations includes the radially adjacent I/O pins of the PSN's. If, at step 926, all PSN's in the selected group have been examined, then the method proceeds to step 928. If, at step 926, all PSN's in the selected group have not been examined, then the method returns to step 910 where steps 910-926 are repeated for each PSN in the group.

To improve the efficiency of the method, each PSN which is examined at steps 910-926 is thereafter removed from further consideration in the group such that it is not re-checked at step 918 when a next PSN is selected. This is done because a short circuit is reflexive (i.e., net A shorted to net B necessarily implies that net B is shorted to net A).

At step 928, it is determined whether all groups of PSN's have been examined for probable short-circuits. If not, then the method returns to step 908 and steps 908-928 are repeated for the next group of PSN's. If all groups have been examined, then the method ends at step 930.

Two lists are produced by the method of the invention: list 920 and list 924. List 920 contains the PSN's which are determined to probably not be short-circuited. List 924 contains each PSN which is short-circuited (probably) and the PSN's to which the short-circuit(s) extend. It may also include the actual I/O pins involved.

This method allows the diagnostic resolution of a test to be increased after the test is run. For example, if nets A and B have the same net signature, then the method will determine whether it is possible for A and B to be short-circuited by examining the adjacency list. Similarly, if nets A, B, C and D all have the same net signature, then this method can determine whether one large short-circuit including A-D exists, or whether two smaller short-circuits (e.g., A-B and C-D) exist.

This method does not provide perfect diagnosis and may still be "fooled". For example, if nets A and B short-circuit together to produce a net signature equivalent to that of net C, and if net C is radially adjacent to either of nets A and B, then it is not possible for the method to determine whether C is also short-circuited. The probability of this occurring, however, is quite low. For example, if the net ID numbers are assigned at random, then the probability of A and B producing the net signature of C is 1/(N-1), where N is the number of nets in the circuit. For a circuit having 1000 nets, this probability is only a fraction of a percent.

If the net ID numbers are assigned by an ordered method (e.g., the Enhanced Test Pattern discussed above) such that the probable combinations will not match nearby net signatures, then the enhancement in resolution (reduction in aliasing and confounding) may be increased by 100-fold or even 1000-fold while still using an optimal length counting sequence.

The computational work involved in this diagnostic method is minimal, especially if physical description 914 is an adjacency list (as discussed above) rather than a full topological description of the circuit board. In addition, the adjacency list need only be generated once for each circuit board type.

The method of the invention is quite flexible. The shorting radius is easily adjusted to conform to the requirements of different soldering processes, board layouts, etc. If the shorting radius is altered, however, the adjacency list (if used) must be re-created.

In the preferred embodiment, a modified counting test pattern is used with the invention. For example, for a board having between 8 and 15 nets, an ID number containing nine bits could be used. The first four bit section is a binary counting number. The second section is a three bit section which is the complement of the three least significant bits of the four bit section. The final two bits include a first bit which is always a "1" and a second bit which is always a "0". This modified counting pattern provides a significant initial reduction in aliasing while maintaining a relatively short test.

While the invention has been particularly shown and described with reference to a preferred embodiment thereof, it will be understood by those skilled in the art that various changes in form and details may be made therein without departing from the scope of the invention.

## Claims

1. A method for increasing the diagnostic resolution of a boundary-scan interconnect test performed on a circuit, wherein the circuit includes a plurality of integrated circuit chips, each integrated circuit chip having a plurality of I/O pins, the I/O pins making electrical interconnection through a plurality of independent conductive nets, said method comprising:
receiving captured test data generated during execution of a boundary-scan interconnect test;
grouping (904) together nets having identical captured test data and
determining (910-926) which nets in a group are likely short-circuited together based on a radial adjacency between their I/O pins.

2. The method of claim 1, wherein said determining step (910-926) includes checking (912) an adjacency list (914) for each net in the group.

3. The method of claim 1, further comprising a step of:
examining the radially adjacent I/O pins to determine (706) the probable location of a short circuit.

4. A method according to claim 1, wherein said captured test data is produced from a plurality of captured test vectors; the method including the steps of:
serially scanning (302) a test vector into the circuit through a scanpath;
broadcasting (304) said test vector from a plurality of output buffers in the circuit over said conductive nets;
capturing (306) said test vector in a plurality of receiving register cells in the circuit;
serially scanning (308) said test vector out of the receiving register cells via said scanpath;
repeating the preceding steps for a plurality of test vectors.

## Patentansprüche

1. Ein Verfahren zum Erhöhen der Diagnoseauflösung eines Boundary-Scan-Verbindungstests, der auf einer Schaltung durchgeführt wird, wobei die Schaltung eine Mehrzahl integrierter Schaltungschips aufweist, wobei jeder integrierte Schaltungschip eine Mehrzahl von I/O-Anschlußstiften aufweist, wobei die I/O-Anschlußstifte eine elektrische Verbindung durch eine Mehrzahl von unabhängigen leitfähigen Knoten herstellen, wobei das Verfahren folgende Schritte aufweist:
Empfangen aufgenommener Testdaten, die während der Ausführung eines Boundary-Scan-Verbindungstests erzeugt werden;
Gruppieren (904) von Netzen, die identische aufgenommene Testdaten aufweisen, zusammen, und
Bestimmen (910 - 926), welche Netze in einer Gruppe wahrscheinlich miteinander kurzgeschlossen sind, basierend auf einer radialen Nachbarschaft zwischen den I/O-Anschlußstiften derselben.

2. Das Verfahren gemäß Anspruch 1, bei dem der Bestimmungsschritt (910 - 926) das Überprüfen (912) einer Nachbarschaftsliste (914) für jedes Netz in der Gruppe aufweist.

3. Das Verfahren gemäß Anspruch 1, das ferner folgenden Schritt aufweist:
Untersuchen der radial benachbarten I/O-Anschlußstifte, um den möglichen Ort eines Kurzschlusses zu bestimmen (706).

4. Verfahren gemäß Anspruch 1, bei dem die aufgenommenen Testdaten aus einer Mehrzahl von aufgenommenen Testvektoren erzeugt werden; wobei das Verfahren folgende Schritte aufweist:
serielles Abtasten (302) eines Testvektors in die Schaltung durch einen Abtastweg;
Senden (304) des Testvektors von einer Mehrzahl von Ausgangspuffern in die Schaltung über die leitfähigen Netze;
Aufnehmen (306) des Testvektors in einer Mehrzahl von Empfangsregisterzellen in der Schaltung;
serielles Abtasten (308) des Testvektors aus den Empfangsregisterzellen über den Abtastweg;
Wiederholen der vorhergehenden Schritte für eine Mehrzahl von Testvektoren.

## Revendications

1. Un procédé destiné à augmenter la résolution de diagnostic d'un test d'interconnexion par balayage en périphérie exécuté sur un circuit, dans lequel le circuit inclut une série de microplaquettes de circuits intégrés, chaque microplaquette de circuit intégré comportant une série de broches entrée/sortie, ou E/S, les broches E/S réalisant une interconnexion électrique par l'intermédiaire d'une série de réseaux conducteurs indépendants, ledit procédé comprenant les étapes consistant à:
recevoir des données de test captées, engendrées pendant l'exécution d'un test d'interconnexion par balayage en périphérie;
grouper (904) entre eux des réseaux pour lesquels les données captées sont identiques et
déterminer (910 à 926), sur la base d'une contiguïté radiale entre leurs broches E/S, quels sont les réseaux d'un groupe qui sont probablement mis en court-circuit entre eux.

2. Le procédé selon la revendication 1, dans lequel ladite étape de détermination (910 à 926) inclut inclut une vérification (912) d'une liste de contiguïtés (914) pour chaque réseau du groupe.

3. Le procédé selon la revendication 1, qui comprend en outre une étape consistant à:
examiner les bornes E/S radialement contigües afin de déterminer (706) l'emplacement probable d'un court -circuit.

4. Un procédé selon la revendication 1, dans lequel lesdites données de test captées sont produites à partir d'une série de vecteurs de test captés; le procédé incluant les étapes consistant à;
introduire sériellement (302) par balayage un vecteur de test dans le circuit par l'intermédiaire d'un trajet de balayage;
diffuser (304) dans le circuit sur lesdits réseaux conducteurs ledit vecteur de test à partir d'une série de tampons de sortie;
capter (306) ledit vecteur de test dans une série de cellules de registre récepteur du circuit;
extraire sériellement (308) par balayage ledit vecteur de test hors des cellules de registre récepteur par l'intermédiaire dudit trajet de balayage;
répéter les étapes précédentes pour une série de vecteurs de test.
